# EUROPEAN PATENT SPECIFICATION

(11) **EP 2 146 924 B1**
(45) Date of publication and mention of the grant of the patent: **06.03.2013**
(21) Application number: 08733447.0
(22) Date of filing: 06.05.2008
(51) Int. Cl.: H01L 21/683, H01L 21/67

(54) **METHOD OF REMOVING MEMS DEVICES FROM A HANDLE SUBSTRATE**
VERFAHREN ZUM ENTFERNEN VON MEMS-BAUELEMENTEN VON EINEM TRÄGERSUBSTRAT
PROCÉDÉ DE RETRAIT DE DISPOSITIFS MEMS FIXÉS SUR UN SUBSTRAT DE MANIPULATION

(30) Priority: 20.05.2007 US 939086 P
(43) Date of publication of application: 27.01.2010
(73) Proprietor: Silverbrook Research Pty. Ltd, Balmain, New South Wales 2041 (AU)
(72) Inventor: PAPWORTH, Paul, Andrew, Balmain, New South Wales 2041 (AU); THELANDER, Jason, Mark, Balmain, New South Wales 2041 (AU); FOOTE, Roger, Mervyn, Lloyd, Balmain, New 2041 (AU); VELLA, Andrew, Leon, Balmain, New South Wales 2041 (AU); JOHNSTONE, David, Mcleod, Balmain, New South Wales 2041 (AU); SILVERBROOK, Kia, Balmain, New South Wales 2041 (AU)
(74) Representative: Moore, Barry
(86) International application number: PCT/AU2008/000626
(87) International publication number: WO 2008/141359

(56) References cited:
- JP-A- 9 321 123
- US-A1- 2005 215 029
- US-A1- 2006 030 120
- US-A1- 2008 006 922
- US-B1- 7 354 802
- US-B2- 6 946 326

## Description

### FIELD OF THE INVENTION

The invention relates to the fabrication of devices incorporating micro-electromechanical systems (MEMS). More particularly, the invention relates to a method of fabricating MEMS devices in VLSI (very large scale integrated) production and then separating them into individual devices.

### BACKGROUND OF THE INVENTION

MEMS devices are often fabricated on a silicon wafer substrate using the lithographic etching and deposition techniques used to fabricate integrated circuits (ICs). In the vast majority of cases, these devices are manufactured in high volumes to minimize the unit cost. Batches of devices are fabricated on one side of a circular wafer of silicon about 8 to 10 inches in diameter.

Once the MEMS structures have been fabricated on one side, the wafer is tessellated or 'diced' as it is known, to separate each individual MEMS device. The dicing involves sawing through the wafer along 'saw streets' between the individual MEMS devices. For brevity, the each individual MEMS device is often referred to as a 'die' which is more generic and in common usage in the art. Also, in accordance with convention, the MEMS devices shall be referred to as having a 'front side' on which the MEMS structures are formed, and a 'back side' which is the supporting silicon wafer. The Applicant has developed a number of MEMS devices, most notably printhead ICs for inkjet printers. These printhead ICs have ink conduits etched from the back side to feed the nozzles on the front side. This deep etching technique is also used to dice the wafer thus eliminating the need to saw the wafer and allowing the streets between the devices to be narrower.

This technique is described in US 6,982,184 to the present Assignee, the contents of which are incorporated herein by cross reference. Briefly, the MEMS structures for each individual device are formed on the front side of the wafer. These are then encased in a layer of sacrificial material for protection. A handle wafer is then bonded to the layer of sacrificial material, usually with a thermal release tape. A suitable tape is Revalpha™ thermal tape, supplied by Nitto Denko. The Revalpha™ tape is a double-sided adhesive tape having a permanent adhesive layer on one side and a thermal adhesive layer (release temperature = 170°C) on the opposite side.

The handle wafer is simply a disc of glass, quartz, alumina or other transparent material. This glass disc is a handle to hold and protect the MEMS devices during the dicing process and any final release etching.

With the front side bonded to the glass handle, the wafer is deep etched from the back side. As discussed above, the deep etching forms the ink channels to the MEMS structures in the front and even deeper etches extend through the silicon wafer to the layer of sacrificial material on the front side. A glass handle is then bonded to the back side of the wafer and the front side glass handle is removed by heating to adhesive release temperature. The sacrificial layer is etched away which then separates the individual MEMS devices and completes the dicing process.

The finished MEMS devices must be removed from the glass handle for packaging or assembly into a larger component. If the MEMS devices are bonded to the glass handle with a thermal tape (e.g. Revalpha, V80 or W90V all made by Nitto Denko), the individual devices can be released by directing hot air onto the die or the glass handle underneath the die. This heats the adhesive to the release temperature (approximately 170°C to 190°C). The single MEMS device can then be lifted away with a vacuum actuated 'die picker'. Unfortunately, heating the adhesive with hot air takes about 15 seconds to 20 seconds per die. For high volume production, this creates a bottle-neck in the fabrication process.

As discussed in US 6,982,184, the MEMS devices can be adhered with a UV release adhesive tape such as SELF-DC made by Sekisui Chemical. Using a mask with a small opening, or an optical fiber torch, the UV release tape directly beneath the die can be UV irradiated from beneath the glass handle. The adhesive releases in about 1 second which offers a large time saving over thermal release using hot air. However, the UV release tape needs to be dried prior to any UV irradiation. This involves transferring the glass handle to an oven for approximately 30 minutes. While this is a batch process, it is still one of the main rate limiting steps of the overall process.

Furthermore, the UV light can tend to diffract as it passes through the glass handle and partially release the adjacent dies. Partially released dies can be slightly askew when fully released and this potentially exposes them to damage by the die picker.

JP9321123A discloses a semiconductor component feeder, whereby an IC chip is carried to a bonding stage, the chip 5 is preheated by a heating means composed of a heater for heating needle guides 47 of a thrust mechanism, a heater for heating an attraction collet 77b and means for preheating each chip 5 on a sheet 14 with dry air. The temperature is stepwise risen to about 100 deg. C by the heater for heating the guides 47 or heater 80 to about 150 deg. C toward a bonding stage temp., thereby relaxing the temp. change of the chip 5.

US6946326 discloses a method and device for protecting micro electromechanical systems structures during dicing of a wafer. A wafer cap protects micro electromechanical system ("MEMS") structures during a dicing of a MEMS wafer to produce individual MEMS dies. A MEMS wafer is prepared having a plurality of MEMS structure sites thereon. Upon the MEMS wafer, the wafer cap is mounted to produce a laminated MEMS wafer. The wafer cap is recessed in areas corresponding to locations of the MEMS structure sites on the MEMS wafer. The capped MEMS wafer can be diced into a plurality of MEMS dies without causing damage to or contaminating the MEMS die.

### SUMMARY OF THE INVENTION

The present teaching provides a method as detailed in claim 1. Also provided is a die picker in accordance with claim 8. Advantageous features are provided in dependent claims. According to a first aspect, the present invention provides a method of removing MEMS devices from a handle substrate, the method comprising the steps of:
providing the handle substrate with the MEMS devices individually bonded to it via a thermal release adhesive that reduces its adhesion to the MEMS device when heated above a threshold temperature;
applying a heat source to at least part of one surface of each of the MEMS devices to heat the MEMS device above the threshold temperature; and,
individually removing the MEMS devices from the handle substrate.

By applying localized heat to a part of the MEMS device to heat the whole device by conduction, the thermal release adhesive in direct contact with the die is heated first and the die is released in a shorter time. This method quickly heats the adhesive to release each die in about I second. This is comparable to UV release adhesive and does not require a 30 minute drying bake. Heating the die with a focused source of heat, localizes the heating of the adhesive. The adhesive bonding the adjacent dies to the glass handle remains unaffected.

Prefereably, the heat source is a laser. Preferably, the MEMS devices are removed from the handle substrate with a die picker that has an elongate arm with a free end configured to engage one of the MEMS devices, and the laser directs a beam through the die picker to heat the MEMS device prior to it removal.

In another preferred embodiment, the heat source is a heated surface configured for contact with the at least part of one surface of the MEMS device. Preferably, the heated surface is on a die picker used to lift the MEMS devices from the handle substrate after releasing the thermal adhesive. In a further preferred form, the die picker has a resistive heater for generating heat, the resistive heater being controlled to keep heating rates and maximum temperatures within predetermined thresholds.

According to a second aspect, the present invention provides a die picker for lifting an integrated circuit die off a supporting substrate, the integrated circuit die being bonded to the supporting substrate with a thermal release adhesive that has reduced adhesion above a threshold temperature, the die picker comprising:
a picker head for releasably engaging the integrated circuit die;
a laser for directing a beam on to a surface of the integrated circuit die, such that the integrated circuit die heats to a temperature above the threshold temperature; and,
a shuttle drive mechanism for moving the picker head relative to the supporting substrate.

Preferably, the beam intensity is controlled such that the integrated circuit die is heated at a predetermined rate. In a further preferred form, the beam intensity is controlled such that the integrated circuit die temperature does not exceed a predetermined maximum.

According to a third aspect, the present invention provides a die picker for lifting an integrated circuit die off a supporting substrate, the integrated circuit die being bonded to the supporting substrate with a thermal release adhesive that has reduced adhesion above a threshold temperature, the die picker comprising:
a picker head for releasably engaging the integrated circuit die, the picker head having a heater for heating at least part of one surface of the integrated circuit die, such that the integrated circuit die heats to a temperature above the threshold temperature; and,
a shuttle drive mechanism for moving the picker head relative to the supporting substrate.

Preferably, the die picker creates a vacuum at the free end to hold the MEMS device as it is removed from the handle substrate. In some embodiments, the elongate arm is tubular and the vacuum is generated by drawing air down the elongate arm and the laser directs a beam through the interior of the elongate arm to the MEMS device engaged with the free end of the die picker.

Preferably the thermal release adhesive heats to the threshold temperature in less than 5 seconds. In a further preferred form the thermal release adhesive heats to the threshold temperature in less than 2 seconds. Preferably the threshold temperature is less than 250°C. In a further preferred form the threshold temperature is between 170°C to 190°C.

### BRIEF DESCRIPTION OF THE DRAWINGS

Preferred embodiments of the invention will now be described by way of example only with reference to the accompanying drawings, in which:
Figure 1 is a schematic section view of a glass handle supporting a series of MEMS devices;
Figure 2 is the schematic section view of Fig. 1 with several of the MEMS devices removed and the die picker moving into place to remove the next MEMS device;
Figure 3 shows the die picker engaging and laser heating the next MEMS device;
Figure 4 shows the vacuum actuated die picker removing the MEMS device from the glass handle; and,
Figure 5 shows another die picker engaging a die and heating via a heater element incorporated in the picker head; and,
Figure 6 shows the MEMS device held to the picker head by a vacuum as it is shuttled from the glass handle.

### DETAILED DESCRIPTION OF THE PREFFERED EMBODIMENTS

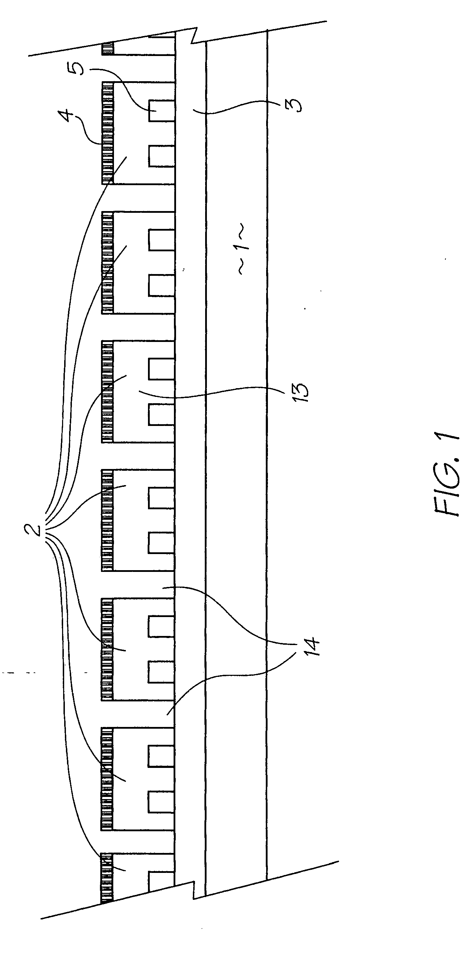

Figure 1 shows the MEMS devices 2 bonded to the glass handle 1 by a layer of thermal release adhesive 3. The process of bonding a silicon wafer of connected dies onto a handle and subsequently dicing them into separate dies is described in the above referenced US 6,982,184 "METHOD OF FABRICATING MEMS DEVICES ON A SILICON WAFER". Also previously discussed, the thermal release adhesive 3 may be in the form of a film or tape which is a laminate with a thermal release adhesive layer in contact with the MEMS devices. Revalpha, V80 or W90V all made by Nitto Denko are typical of these types of release tapes. The MEMS devices 2 are shown after being diced into separate dies. As explained in the Background section, the dice streets 14 between each MEMS device 2 are formed by deep etches from the back side 5 of the silicon wafer 13. The back side 5 may also have other features etched into it such as ink feed channels. On the front side of the silicon wafer 13 are the MEMS structures 4 such as the ink ejection nozzles of an inkjet printhead IC.

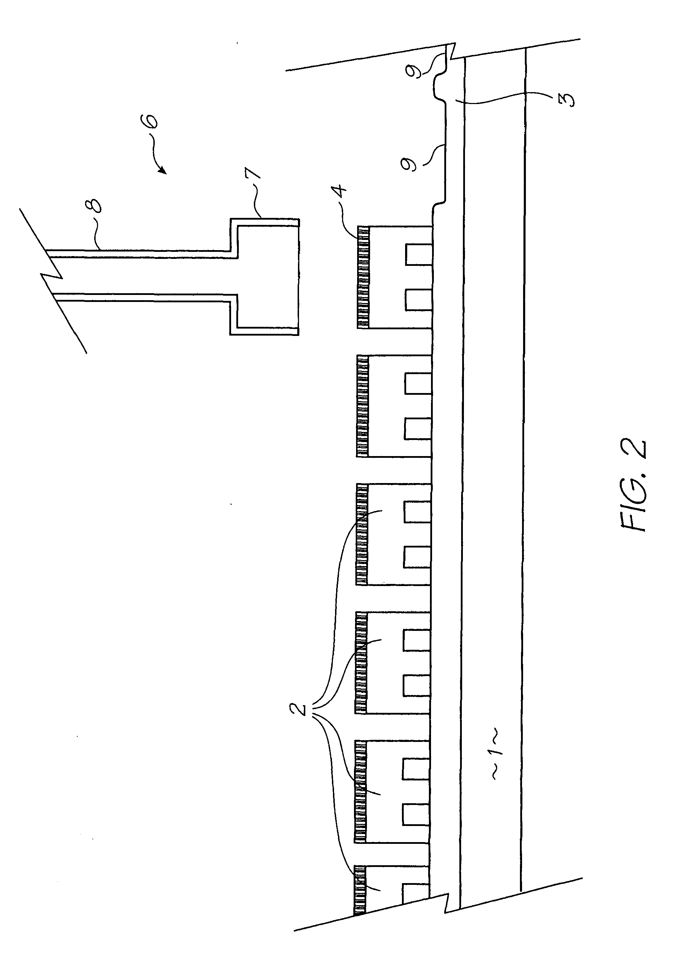

In Figure 2, some of the MEMS devices 2 have been removed and the die picker 6 is aligning with the next MEMS device. Shallow localized pits 9 in the adhesive layer 9 indicate where MEMS devices have been previously taken. The die picker 6 has a tube 8 that is open at the free end 7 to engage the top of the MEMS device 2 without damage to the MEMS structures 4.

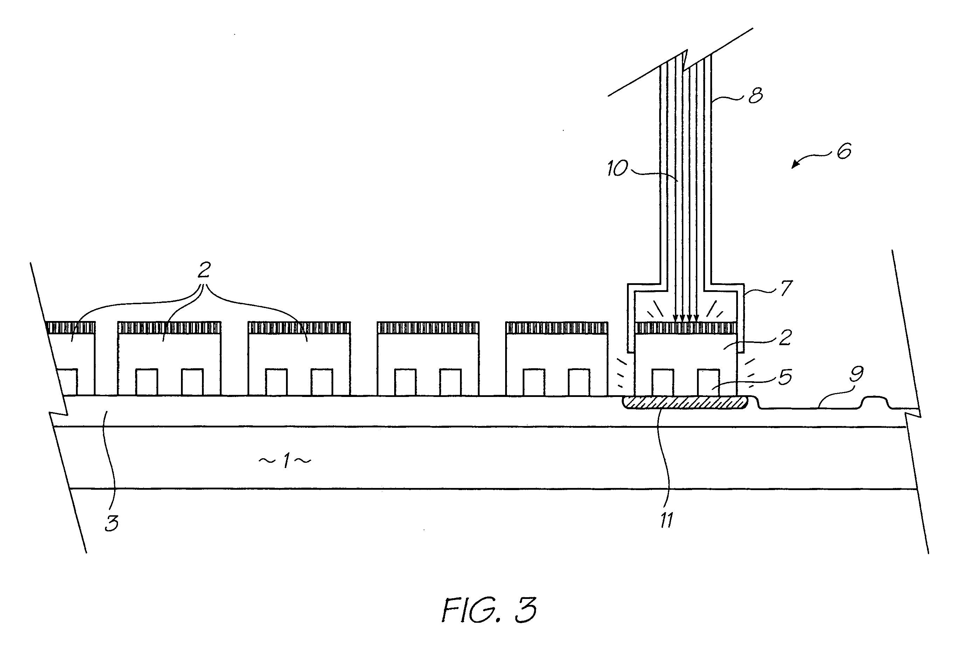

Figure 3 shows the die picker 6 engaging the front side of a MEMS device 2. A laser beam 10 is directed down the tube 8 to heat the MEMS device 2. The power of the laser will determine the rate of temperature increase but the heat must conduct through the MEMS device 2 to the adhesive 11 directly contacting the back side 5. To protect the MEMS structures 4 on the front side, the release temperature of the adhesive 3 should be less that 250°C; about 180°C is typical. Depending on the thickness of the MEMS device 2, the adhesive 11 in direct contact with the back side 5 should lose adhesion in about 1 second. However, it will be appreciated that heating to the release temperature can take as long as 5 seconds or more and still offer time efficiencies over the prior art techniques. The microprocessor controlling the picker can adjust the laser beam intensity to regulate the heating rate and the maximum temperature to protect the delicate MEMS structures from damage.

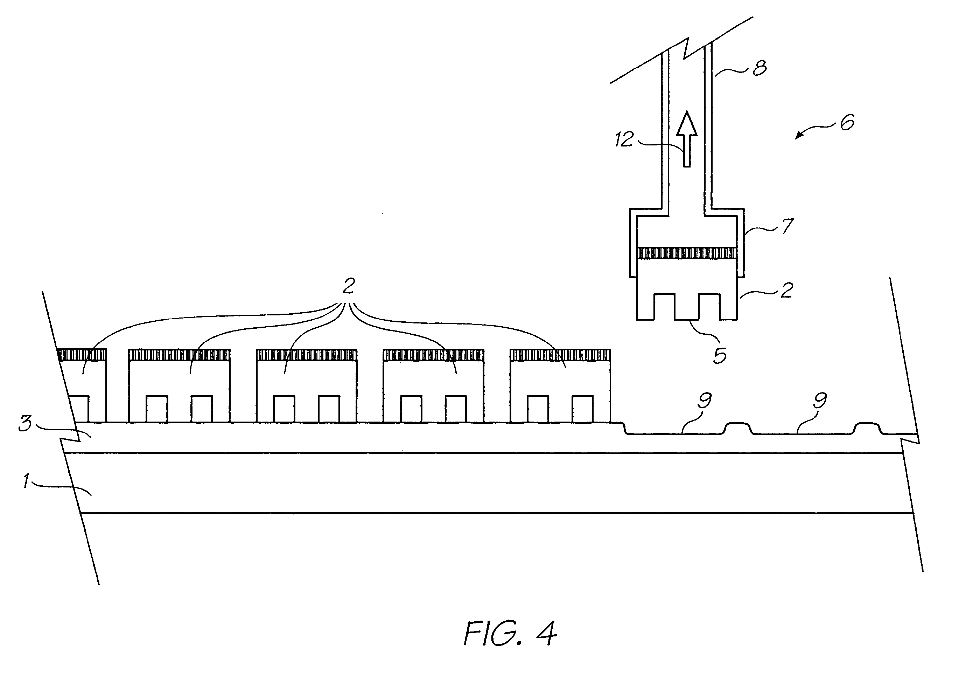

Without the adhesive bond, the die picker 6 can lift the MEMS device 2 away as shown in Figure 4. A slight vacuum 12 is created in the tube 8 and therefore the end 7. This holds the MEMS device 2 until it is packaged or installed into a larger component. The die 2 remains hot as it is lifted away so that no adhesive residue clings to the back side 5. Shallow localized pits 9 in the adhesive layer 3 are all that remain.

This technique avoids the need to do a drying bake in an oven as is the case with UV release adhesive tapes. However, using a laser to heat the die and underlying adhesive is 15 to 20 times quicker than the conventional hot air stream method of releasing thermal adhesives. Streamlining the die picking procedure using the present invention allows a single die picker to process more than six wafers (8 inch dia) per hour while keeping yield losses (damaged dies) to less than 1%.

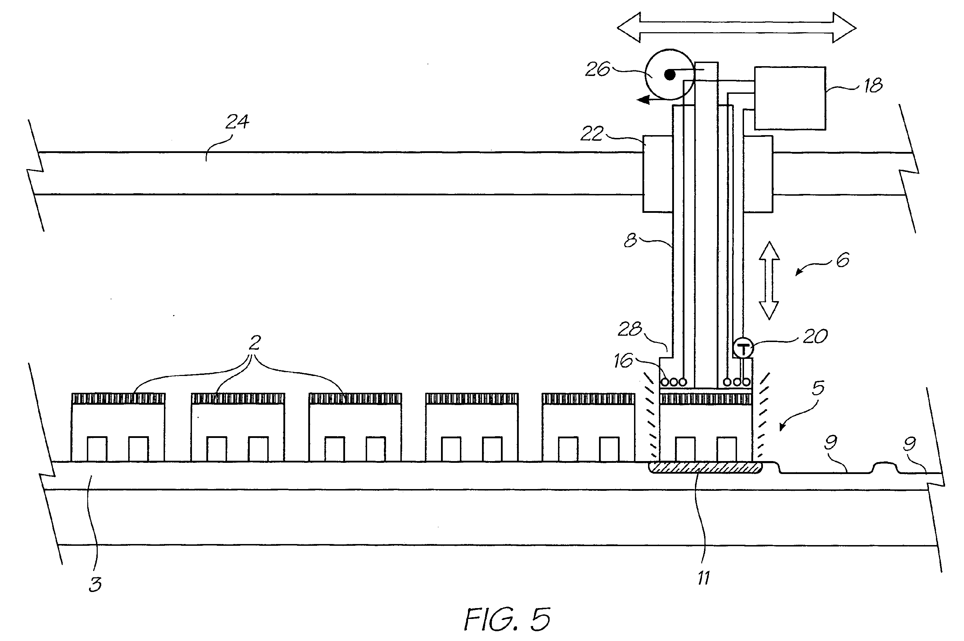

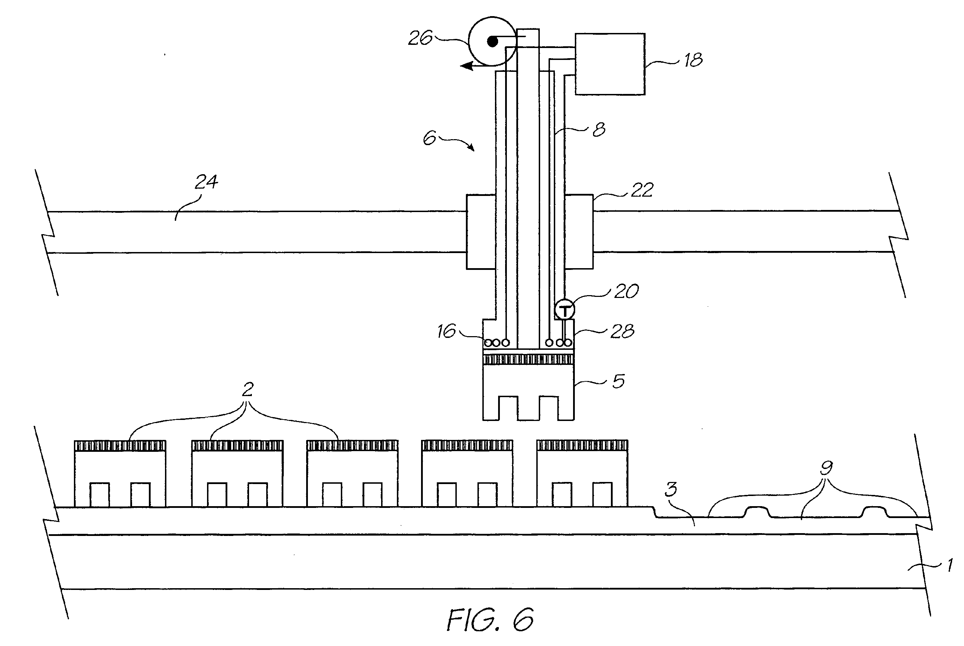

Figure 5 and 6 show another embodiment of the die picker 6 which has a heater element 16 incorporated into the picker head 28. The resistive element 16 enables more accurate control of the heating rate via the controller 18 and feedback from a temperature sensor 20. Furthermore the element 16 can apply heat to a larger area on the MEMS device 5. Heating the die with a laser is more localized and can damage some MEMS dies because of the high heating rates and differentials in the thermal expansion rates of adjacent components within the MEMS structures.

As shown in Figure 5, the picker 6 lowers the picker head 28 onto the MEMS device 5. The controller 18 energizes the heater element 16 and the temperature sensor 20 monitors the heating rates and the temperature. The MEMS die 5 heats by conduction and the temperature of the adhesive 11 in direct contact is raised above the threshold temperature. As with the laser heating, the adhesion is lost within 1 second but this can be extended if the integrated circuitry on the die requires lower heating rates.

Figure 6 shows the shuttle drive 22 lifting and moving the MEMS die 5 away from the handle wafer 1. Suction from the vacuum pump 26 holds the die 5 as the drive motors 22 lift the picker head 28 and move the picker 6 along the rail 24. Shallow pits 9 remain in the adhesive layer 3 once the dies have been removed from the glass handle 1.

The embodiment of the invention has been described here by way of example only. It is to be considered merely illustrative and in no way limiting on the scope of the broad inventive concept.

## Claims

1. A method of removing MEMS devices from a handle substrate, the method comprising the steps of:
providing the handle substrate with the MEMS devices individually bonded to it via a thermal release adhesive that reduces its adhesion to the MEMS device when heated above a threshold temperature;
applying a heat source to at least part of one surface of each of the MEMS devices to heat the MEMS device above the threshold temperature; and,
individually removing the MEMS devices from the handle substrate with a die picker that has an elongate arm with a free end configured to engage one of the MEMS devices,
**characterized in that**:
the heat source is a laser which directs a beam through the die picker to heat the MEMS device prior to its removal.

2. A method according to claim 1 further comprising the step of controlling the beam intensity such that the integrated circuit die is heated at a predetermined rate.

3. A method according to claim 1 further comprising the step of controlling the beam intensity such that the integrated circuit die temperature does not exceed a predetermined maximum.

4. A method according to any one of the preceding claims, wherein the thermal release adhesive heats to the threshold temperature in less than 5 seconds.

5. A method according to claim 4 wherein the thermal release adhesive heats to the threshold temperature in less than 2 seconds.

6. A method according to any one of the preceding claims, wherein the threshold temperature is less than 250°C.

7. A method according to any one of the preceding claims, wherein the threshold temperature is between 170°C to 190°C.

8. A die picker (6) for performing the method according to any one of the preceding claims:
the die picker having a picker head (28) for releasably engaging the MEMS device (2),
and, a shuttle drive mechanism (22) for moving the picker head relative to the handle substrate,
**characterized by** a laser (10) for directing a beam through the die picker on to a surface of the MEMS device, such that the MEMS device heats to a temperature above the threshold temperature prior to its removal.

## Patentansprüche

1. Verfahren zum Entfernen von MEMS-Bauelementen von einem Trägersubstrat, wobei das Verfahren die folgenden Schritte umfasst:
Versehen des Trägersubstrats mit den MEMS-Bauelementen, die mithilfe eines wärmelösbaren Klebstoff einzeln an dieses gebunden sind, der seine Haftung an das MEMS-Bauelement verringert, wenn es über eine Schwellenwerttemperatur erhitzt wird;
Anlegen einer Wärmequelle an zumindest einen Teil einer Oberfläche von jedem der MEMS-Bauelemente, um das MEMS-Bauelement über die Schwellenwerttemperatur zu erhitzen; und
einzelnes Entfernen der MEMS-Bauelemente vom Trägersubstrate mit einer Chipaufnahmevorrichtung, die einen länglichen Arm mit einem freien Ende aufweist, das konfiguriert ist, um lösbar mit einem der MEMS-Bauelemente in Eingriff zu gelangen,
**dadurch gekennzeichnet, dass**:
die Wärmequelle ein Laser ist, der einen Strahl durch die Chipaufnahmevorrichtung lenkt, um das MEMS-Bauelement vor seiner Entfernung zu erhitzen.

2. Verfahren nach Anspruch 1, ferner umfassend den Schritt des Steuerns der Strahlenintensität, so dass der integrierte Schaltungschip bei einer vorab definierten Rate erhitzt wird.

3. Verfahren nach Anspruch 1, ferner umfassend den Schritt des Steuerns der Strahlenintensität, so dass die Temperatur des integrierten Schaltungschips ein vorab definiertes Maximum nicht übersteigt.

4. Verfahren nach einem der vorstehenden Ansprüche, wobei sich der wärmelösbare Klebstoff innerhalb von weniger als 5 Sekunden auf die Schwellenwerttemperatur erhitzt.

5. Verfahren nach Anspruch 4, wobei sich der wärmelösbare Klebstoff innerhalb von weniger als 2 Sekunden auf die Schwellenwerttemperatur erhitzt.

6. Verfahren nach einem der vorstehenden Ansprüche, wobei die Schwellenwerttemperatur weniger als 250 °C beträgt.

7. Verfahren nach einem der vorstehenden Ansprüche, wobei die Schwellenwerttemperatur zwischen 170 °C und 190 °C beträgt.

8. Chipaufnahmevorrichtung (6) zum Durchführen des Verfahrens nach einem der vorstehenden Ansprüche,
wobei die Chipaufnahmevorrichtung einen Aufnahmevorrichtungskopf (28), um lösbar mit dem MEMS-Bauelement (2) in Eingriff zu gelangen, und einen Schlittenantriebsmechanismus (22) aufweist, um den Aufnahmevorrichtungskopf relativ zum Trägersubstrat zu bewegen,
**gekennzeichnet durch** einen Laser (10) zum Lenken eines Strahls **durch** die Chipaufnahmevorrichtung auf eine Oberfläche des MEMS-Bauelements, so dass sich das MEMS-Bauelement vor seiner Entfernung auf eine Temperatur über der Schwellenwerttemperatur erhitzt.

## Revendications

1. Procédé de retrait de dispositifs MEMS d'un substrat de manipulation, le procédé comprenant les étapes de :
- disposition du substrat de manipulation avec les dispositifs MEMS qui lui sont individuellement liés par l'intermédiaire d'un adhésif à décollement thermique qui réduit son adhérence au dispositif MEMS lorsqu'il est chauffé au-dessus d'une température de seuil ;
- application d'une source de chaleur à au moins une partie d'une surface de chacun des dispositifs MEMS pour chauffer le dispositif MEMS au-dessus de la température de seuil ; et,
- retrait individuel des dispositifs MEMS du substrat de manipulation avec un dispositif de saisie de puce qui a un bras allongé ayant une extrémité libre configurée pour venir en prise avec l'un des dispositifs MEMS,
**caractérisé par le fait que** :
- la source de chaleur est un laser qui dirige un faisceau à travers le dispositif de saisie de puce pour chauffer le dispositif MEMS avant son retrait.

2. Procédé selon la revendication 1, comprenant en outre l'étape de commande de l'intensité de faisceau de telle sorte que la puce de circuit intégré est chauffée à une vitesse prédéterminée.

3. Procédé selon la revendication 1, comprenant en outre l'étape de commande de l'intensité de faisceau de telle sorte que la température de puce de circuit intégré ne dépasse pas un maximum prédéterminé.

4. Procédé selon l'une quelconque des revendications précédentes, dans lequel l'adhésif à décollement thermique chauffe jusqu'à la température de seuil en moins de 5 secondes.

5. Procédé selon la revendication 4, dans lequel l'adhésif à décollement thermique chauffe jusqu'à la température de seuil en moins de 2 secondes.

6. Procédé selon l'une quelconque des revendications précédentes, dans lequel la température de seuil est inférieure à 250°C.

7. Procédé selon l'une quelconque des revendications précédentes, dans lequel la température de seuil se situe entre 170°C et 190°C.

8. Dispositif de saisie de puce (6) pour mettre en oeuvre le procédé selon l'une quelconque des revendications précédentes :
- le dispositif de saisie de puce ayant une tête de dispositif de saisie (28) pour venir en prise de manière libérable avec le dispositif MEMS (2), et
- un mécanisme d'entraînement à navette (22) pour déplacer la tête de dispositif de saisie par rapport au substrat de manipulation,
**caractérisé par** un laser (10) pour diriger un faisceau à travers le dispositif de saisie de puce sur une surface du dispositif MEMS, de telle sorte que le dispositif MEMS chauffe jusqu'à une température au-dessus de la température de seuil avant son retrait.
